# EUROPÄISCHE PATENTSCHRIFT

(11) **EP 3 465 754 B1**
(45) Veröffentlichungstag und Bekanntmachung des Hinweises auf die Patenterteilung: **13.01.2021**
(21) Anmeldenummer: 17808003.2
(22) Anmeldetag: 16.11.2017
(51) Int. Cl.: H01L 25/075, H01L 25/16

(54) **KOMPAKTE LEUCHTDIODEN-ANORDNUNG**
COMPACT LIGHT-EMITTING DIODE ARRANGEMENT
ENSEMBLE DE DIODES ÉLECTROLUMINESCENTES COMPACT

(30) Priorität: 08.12.2016 DE 102016014649
(43) Veröffentlichungstag der Anmeldung: 10.04.2019
(73) Patentinhaber: INOVA Semiconductors GmbH, 81671 München (DE)
(72) Erfinder: NEUMANN, Roland, 81671 München (DE)
(74) Vertreter: Reich, Jochen
(86) Internationale Anmeldenummer: PCT/EP2017/001349
(87) Internationale Veröffentlichungsnummer: WO 2018/103880

(56) Entgegenhaltungen:
- WO-A1-2008/025625
- WO-A1-2008/025625
- WO-A2-2009/140947
- WO-A2-2009/140947
- DE-A1-102011 004 746
- DE-A1-102011 004 746
- US-A1- 2009 021 955
- US-A1- 2009 021 955

## Beschreibung

Die vorliegende Erfindung ist gerichtet auf eine kompakte Leuchtdioden-Anordnung, welche generisch einsetzbar ist, jedoch aufgrund der kompakten Bauart insbesondere für die Verwendung in einem Fahrzeug vorteilhaft ist. So kann die kompakte Leuchtdioden-Anordnung beispielsweise als Innenraumbeleuchtung in einem Automobil Einsatz finden. Die vorliegende Erfindung ist ferner gerichtet auf eine Fahrzeugkomponente aufweisend die kompakte Leuchtdioden-Anordnung. Ferner wird ein Verfahren zur Herstellung der kompakten Leuchtdioden-Anordnung vorgeschlagen sowie ein Computerprogrammprodukt mit Steuerbefehlen, welche das vorgeschlagene Verfahren implementieren.

WO 2008/025625 zeigt ein Leuchtmodul mit mindestens einer auf einem Substrat angeordneten Leuchtdiode (LED), wobei das Substrat als Siliziumsubstrat und die Leuchtdiode als Leuchtdioden-Chip ausgebildet ist.

WO 2009/140947 A2 zeigt ein opto-elektronisches Modul umfassend eine Träger-Substratschicht mit verschiedenen Schaltkreisen, die in oder auf der Träger-Substratschicht auf Waferlevelebene in Frontend-Prozessen vorstrukturiert worden sind.

DE 10 2011 004 746 A1 zeigt eine Halbleiter-Leuchtvorrichtung mit einem Gehäuse, mindestens einer in dem Gehäuse untergebrachten Wärmesenke, wobei die Wärmesenke mit der mindestens einen Halbleiterlichtquelle thermisch verbunden ist, und einer in dem Gehäuse untergebrachten aktiven Kühleinrichtung.

Gemäß bekannter Verfahren werden Leuchtdioden, insbesondere im Automobilbereich, in vielen Einsatzszenarien verwendet. So ist es beispielsweise bekannt Leuchtdioden derart in Serie zu schalten, dass diese die optische Illusion eines fortlaufenden Bandes hervorrufen. Hierzu ist es bekannt, Leuchtdioden beispielsweise mittels Pulsweitenmodulation derart anzusprechen, dass ein Dimmen der Helligkeit erfolgt. Somit ist es also möglich mehrere Leuchtdioden linear in Serie zu schalten und somit optisch ein umlaufendes Band zu erzeugen. Hierzu ist es möglich die einzelnen Leuchtdioden derart anzusteuern, dass sie in ihrem Zusammenwirken einen sich optisch bewegenden Leuchtstreifen erzeugen. Hierzu werden einzelne Leuchtdioden, welche vorerst ausgeschaltet sind, bis zur vollen Leuchtkraft herauf gedimmt und anschließend wieder herab gedimmt. Durch geschickte Ansteuerung der Mehrzahl von Leuchtdioden entsteht somit innerhalb eines Bands von Leuchtdioden die optische Illusion einer Welle.

Gerade in der Automobilbranche besteht jedoch das technische Problem, dass Leuchtdioden auch sicherheitsrelevante Funktionen bereitstellen. So sind Leuchtdioden bekannt, die als Warnleuchten fungieren oder aber auch einfach nur ein ambientes Licht bereitstellen. In beiden Anwendungsszenarien werden hohe Anforderungen an die verwendeten Leuchtdioden gesetzt, da diese zuverlässig arbeiten müssen und insbesondere farbtreu sein sollen. Hierbei besteht also die technische Hürde, eine Leuchtdiode generell zwar kompakt auszuarbeiten, hierbei jedoch dennoch die Zuverlässigkeit und Farbtreue zu gewährleisten.

Gemäß dem Stand der Technik ist es insbesondere nachteilig, dass sich gewisse Bauarten von Leuchtdioden mitsamt einer entsprechenden Ansteuerung für manche Einsatzszenarien nicht eignen. So werden beispielsweise in der Automobilindustrie besondere Anforderungen an die Abmessungen der Leuchtdioden mitsamt Steuerwerk gestellt. Hierbei ist zu beachten, dass Leuchtdioden typischerweise nicht einzeln verbaut werden, sondern oftmals in großer Stückzahl. Eine nachteilige Abmessung wirkt sich somit mehrfach negativ aus. Oftmals ist es somit jedoch nicht möglich eine bestimmte Anzahl von Leuchtdioden mitsamt Steuerwerk auf einer vorgegebenen Fläche anzubringen. Ferner ist es bei ungünstiger Abmessung nachteilig, dass ein gewünschter ästhetischer Effekt nicht erreicht werden kann, da sich die Abmessungen herkömmlicher Leuchtdioden-Anordnungen nicht für ein bestimmtes Muster eignen.

Es ist daher eine Aufgabe der vorliegenden Erfindung eine kompakte Leuchtdioden-Anordnung vorzuschlagen, welche es ermöglicht Leuchtdioden mitsamt Steuerwerk mit besonders geringer Abmessung bereitzustellen. Hierbei ist zusätzlich zu gewährleisten, dass die entsprechenden Leuchtdioden trotz der kompakten Bauweise farbtreu und zuverlässig arbeiten. Es ist ferner eine Aufgabe der vorliegenden Erfindung eine Fahrzeugkomponente vorzuschlagen, mit kompakter Leuchtdioden-Anordnung. Ferner ist es eine Aufgabe der vorliegenden Erfindung ein Verfahren zur Herstellung der kompakten Leuchtdioden-Anordnung vorzuschlagen, sowie ein Computerprogrammprodukt mit Steuerbefehlen, welche das vorgeschlagene Verfahren implementieren.

Die Aufgabe wird gelöst durch eine kompakte Leuchtdioden-Anordnung zur Verwendung in einem Fahrzeug gemäß den Merkmalen des Patentanspruchs 1. Weitere Ausgestaltungen sind in den Unteransprüchen angegeben.

Demgemäß wird eine kompakte Leuchtdioden-Anordnung zur Verwendung in einem Fahrzeug vorgeschlagen, aufweisend eine Mehrzahl von Leuchtdioden, wobei die Leuchtdioden mitsamt einem Steuerwerk, welches eingerichtet ist, die Helligkeitsintensität der Leuchtdioden jeweils einzustellen, einstückig in einem gemeinsamen Gehäuse angeordnet sind.

Während die vorgeschlagene kompakte Leuchtdioden-Anordnung in einer Vielzahl von Einsatzszenarien eingesetzt werden kann, so eignet sie sich insbesondere zur Verwendung in einem Fahrzeug, vorzugsweise in einem Fahrzeuginnenraum. Dies ist deshalb der Fall, da die Integration der Leuchtdioden mit dem Steuerwerk zu einer geringen Abmessung der Leuchtdiodeneinheit führt und somit eine besonders kompakte Leuchtdioden-Anordnung geschaffen wird.

Die Verwendung in einem Fahrzeug stellt darauf ab, dass beispielsweise in einem Fahrzeuginnenraum stets eine gewisse Temperatur vorherrscht, die sich in einem absehbaren Rahmen bewegt. So werden einzelne Fahrzeugteile typischerweise nicht über die Maßen erhitzt, da sich beispielsweise lediglich großflächige Autoteile unter Sonneneinstrahlung derart erhitzen, dass sie unter einer erheblichen Wärmeentwicklung leiden. Somit eignet sich die vorgeschlagenen Leuchtdioden-Anordnung insbesondere zur Verwendung in einem Fahrzeuginnenraum, der typischerweise nicht unter eine bestimmte Temperaturgrenze fällt und ferner auch eine gewisse Temperaturobergrenze nicht überschreitet. Somit gelten hierbei andere Anforderungen als bezüglich herkömmlichen Leuchtdioden, welche größeren Temperaturschwankungen ausgesetzt sind. Insbesondere hat ein Fahrzeug eine charakteristische Verwendung der Leuchtdioden, derart, dass beispielsweise ein Leuchtdiodenbetrieb von länger als 10 Stunden eher untypisch ist. Hierbei wurde besonders überraschend herausgefunden, dass auch bei einer Temperaturentwicklung der Leuchtdioden an sich trotzdem die Bauweise einer Leuchtdioden-Anordnung kompakt ausgestaltet werden kann.

So beschränken sich die Temperaturschwankungen, verglichen mit anderen Anwendungsszenarien im Wesentlichen auf einen Startvorgang des Fahrzeugs, zu dem noch eine sehr niedrige oder sehr hohe Temperatur im Fahrzeuginnenraum vorherrschen kann. Sobald jedoch eine Innenbeleuchtung aktiviert wird, wird der Fahrer die Temperatur für ihn subjektiv angenehm regeln und somit eine gemäßigte, typischerweise gleichmäßige Temperatur einstellen. Somit handelt es sich bei einem Fahrzeuginnenraum generell um einen klimatisierten Bereich, der dennoch aufgrund Sonneneinstrahlung oder Heizungswärme einer Kompensation einer Helligkeitsintensität der Leuchtdioden bedarf. Dies sind somit andere Voraussetzungen, wie sie beispielsweise bei einer Leuchtdioden-Ansteuerung im Außenbereich berücksichtigt werden müssen. Dies stellt ebenfalls lediglich einen Aspekt der Erfindung dar.

Somit wurde also erfindungsgemäß überraschend erkannt, dass die Verwendung von Leuchtdioden in einem Fahrzeug bestimmte technische Voraussetzungen aber auch Möglichkeiten schafft. So wurde erfindungsgemäß die technische Hürde überwunden, dass eine kompakte Bauweise aufgrund einer Wärmeentwicklung gemäß herkömmlicher Verfahren nicht möglich ist. Speziell im Automobilbereich tritt hierbei jedoch der Vorteil ein, dass sich Leuchtdioden oftmals nicht in einem Dauerbetrieb befinden, sondern punktuell angesprochen werden. Liefert beispielsweise eine Leuchtdiode einen Wamhinweis, so wird diese lediglich über einen Verlauf von wenigen Sekunden angesprochen. Dies stellt ebenfalls lediglich einen Aspekt der Erfindung dar. Hierbei besteht auch die Möglichkeit, dass ein Warnhinweis dadurch gegeben wird, dass eine Leuchtdiode von einer ersten Farbe in eine zweite Farbe wechselt. So kann beispielsweise einem Fahrer mittels eines kurzen Aufleuchtens einer Leuchtdiode an einem Rückspiegel signalisiert werden, dass er auf ein zurückliegendes oder leicht versetzt fahrendes Fahrzeug achten soll. Hierzu kann beispielsweise ein Spurwechselassistent implementiert werden, der dem Fahrer mittels einer Leuchtdiode in einem Außenspiegel signalisiert, dass in einem toten Winkel ein versetztes Fahrzeug fährt. So kann diese Leuchte lediglich dann ein Signal geben, solange sich das Fahrzeug in diesem toten Winkel befindet und somit ein Spurwechsel ausgeschlossen ist. Verlässt ein Fahrzeug den toten Winkel, so erlischt auch wieder die Leuchtdiode. Ferner ist es möglich einen Warnhinweis mittels einer Helligkeitserhöhung einer sich bereits in Betrieb befindlichen Leuchtdiode zu geben. Hierbei kann eine vorherrschende Farbeinstellung beibehalten werden.

Somit kann also aufgrund der Verwendung in einem Fahrzeug eine neuartige kompakte Leuchtdioden-Anordnung geschaffen werden die sich bei Einsatzszenarien eignet, die lediglich einen kurzen Betrieb der Leuchtdioden-Anordnung vorsehen. Dies kann beispielsweise ein Einsatzszenario sein, welches ein Aufleuchten der Leuchtdioden von weniger als einem Tag vorsieht.

Eine Mehrzahl von Leuchtdioden kann beispielsweise als drei oder vier Leuchtdioden vorliegen, welche jeweils rotes, grünes oder blaues Licht bereitstellen und optional zusätzlich ein weißes Licht bereitstellen. Eine Mehrzahl von Leuchtdioden kann aber auch derart realisiert werden, dass diese Leuchtdiodengruppen in Serie geschaltet werden, derart, dass ein fortlaufendes Band oder eine flächige Leuchtdioden-Anordnung entsteht. So ist es besonders vorteilhaft die Mehrzahl von Leuchtdioden derart anzuordnen, dass der optische Eindruck eines einzigen Leuchtmittels einer gewissen Geometrie entsteht. Insbesondere eignet sich hierbei eine Anordnung die ein Rechteck oder ein Band vorsieht. Hierbei werden die Leuchtdioden mittels eines Steuerwerks angesprochen, welches die jeweilige Helligkeitsintensität einstellt. Insbesondere ist das Steuerwerk auch geeignet ein Mischverhältnis der einzelnen Leuchtdioden bezüglich ihrer Abstrahlung derart einzustellen, dass sich ein gewünschter Farbton bzw. eine gewisse Leuchtintensität einstellt. Hierbei ist es möglich, dass das Steuerwerk mit weiteren Komponenten kommuniziert, welche außerhalb der Leuchtdioden-Anordnung angeordnet sind. Das Steuerwerk übernimmt jedoch die direkte Kommunikation mit den einzelnen Leuchtdioden und steuert diese in gewünschter Weise an. Beispielsweise kann auch eine übergeordnete Steuereinheit vorgesehen werden, welche wiederum mit den einzelnen Steuerwerken unterschiedlicher Leuchtmittel kommuniziert. So kann beispielsweise eine fortlaufende Welle eines Leuchtdioden-Bands derart erzeugt werden, dass eine externe Steuereinheit die unterschiedlichen Steuerwerke jeweils einer Leuchtdioden-Anordnung anspricht. Bei der übergeordneten Steuereinheit kann es sich um einen Mikrocontroller oder allgemein einen Controller handeln.

Das Steuerwerk ist eingerichtet, die Helligkeitsintensität der Leuchtdioden jeweils derart einzustellen, dass die Leuchtdioden einzeln bezüglich ihrer Leuchtintensität eingestellt werden können. Somit ist es auch möglich gleichzeitig drei oder vier Leuchtdioden der Art anzusteuern, dass sich ein bestimmtes Mischverhältnis einstellt. Aufgrund von Alterungsprozessen können jedoch einzelne Leuchtdioden an Helligkeitsintensität im Laufe eines Lebenszyklus nachlassen. Hierbei kann es sogar möglich werden, eine einzelne Leuchtdiode bzw. eine Leuchtdiodengruppe auszuwechseln. Eine Leuchtdioden Gruppe kann beispielsweise als drei oder vier Leuchtdioden zusammengefasst werden, welche rotes, grünes und blaues und optional weißes Licht bereitstellen. Wird eine solche Leuchtdiodengruppe ausgetauscht, so ist es besonders vorteilhaft, das Steuerwerk gleich mit auszutauschen, um eine aufwändige Fehlersuche zu vermeiden. Hierbei ist es erfindungsgemäß besonders vorteilhaft, dass das Steuerwerk mitsamt den Leuchtdioden in einem gemeinsamen Gehäuse einstückig angeordnet ist.

Einstückig bedeutet hierbei, dass die einzelnen Leuchtdioden, also die Mehrzahl von Leuchtdioden, und das Steuerwerk derart miteinander verbunden werden, dass diese nicht zerstörungsfrei trennbar sind. Dies impliziert nicht zwingendermaßen, dass die Mehrzahl von Leuchtdioden und das Steuerwerk an sich einstückig mittels eines direkten Kontakts ausgestaltet werden, sondern vielmehr schafft das Gehäuse eine auswechselbare Einheit, welche das Steuerwerk und die Mehrzahl von Leuchtdioden umfasst. Somit stellt sich wiederum der technische Effekt ein, dass bei Wartungseinheiten die Gesamtheit aus Leuchtdioden und Steuerwerk ausgetauscht werden kann.

Generell ist es möglich, dass bei einer Leuchtdioden-Anordnung neben natürlichen Alterungsprozessen auch eine physische Beeinträchtigung der Baugruppe entsteht. So ist es beispielsweise möglich, dass aufgrund ungewünschter Krafteinwirkung eine Deformation der Leuchtdioden-Anordnung auftritt. Hierbei wäre es gemäß herkömmlicher Anordnungen möglich, dass die Leuchtdioden an sich beschädigt sind, dass das Steuerwerk beschädigt ist oder dass eine Leiterbahn zerstört wurde.

Somit ist es gemäß dem Stand der Technik besonders nachteilig, dass die Leuchtdioden-Anordnung bezüglich des zugrunde liegenden Fehlers analysiert werden muss. Erfindungsgemäß wird dies dadurch überwunden, dass das Steuerwerk und die Mehrzahl von Leuchtdioden einstückig in einem Gehäuse angeordnet sind. Somit wird also eine kompakte Leuchtdioden-Einheit geschaffen, welche als Ganzes einfach auswechselbar ist. Insbesondere stellt sich der vorteilhafte Effekt ein, dass die Leiterbahnen typischerweise zerstörungsfrei sind, da diese lediglich von minimaler Länge sind. Bei herkömmlichen Anordnungen werden die Leuchtdioden und das Steuerwerk räumlich getrennt voneinander angeordnet, weshalb dort längere Leiterbahnen notwendig sind. Einzig durch die vorgeschlagene Anordnung wird dieser Nachteil überwunden und die geschaffene Anordnung ist weniger fehleranfällig.

Bei dem Gehäuse kann es sich vorzugsweise um ein Gehäuse handeln, wie es generell für Leuchtdioden vorgesehen ist. Insbesondere eignet sich hierbei ein Kunststoffgehäuse, welches die Leuchtdioden umschließt. Somit ist es erfindungsgemäß besonders vorteilhaft, dass das Steuerwerk und die Leuchtdioden in einem gemeinsamen Gehäuse angeordnet werden, welches sowieso für die Leuchtdioden vorzusehen ist. Dies verhindert nicht, dass weitere Trägerelemente vorzusehen sind oder aber auch das beispielsweise die Leuchtdioden mit einem weiteren, transparenten Kunststoff ummantelt sind. Als Gehäuse eignet sich insbesondere ein Chipgehäuse, auch als Package bezeichnet.

Insbesondere ist es vorteilhaft, die Mehrzahl von Leuchtdioden und das Steuerwerk in einem einzigen Arbeitsschritt in ein Gehäuse einzusetzen bzw. das Gehäuse rund um die Bauelemente anzuordnen. Hierbei kennt der Fachmann bestehende Verfahren, die ein beispielsweise formschlüssiges Ummanteln von Leuchtdioden und nunmehr auch dem Steuerwerk bewerkstelligen. Insbesondere ist es möglich einzelne Komponenten zu gießen. Somit soll eine einstückige Baugruppe geschaffen werden, die in einem gemeinsamen Gehäuse angeordnet ist. Hierbei ist darauf zu achten, dass entsprechende Kommunikationsleitungen bzw. eine Stromversorgung von außerhalb der Leuchtdioden-Anordnung gewährleistet sind.

Gemäß einem Aspekt der vorliegenden Erfindung ist das Steuerwerk mitsamt einer Kommunikationseinheit und einem Leuchtdioden-Treiber in dem Gehäuse verbaut. Dies hat den Vorteil, dass alle Komponenten, welche zur direkten Ansteuerung der Leuchtdioden notwendig sind innerhalb des gemeinsamen Gehäuses angeordnet werden können. Typischerweise implementiert ein Mikrocontroller eine bestimmte Logik, welche von dem Leuchtdioden-Treiber derart umgesetzt wird, dass die Leuchtdioden mit einer bestimmten Spannung bzw. Stromstärke angesprochen werden. Somit werden die einzelnen Leuchtdioden bezüglich ihrer Helligkeitsintensität angepasst. Insbesondere ist es hierbei vorteilhaft, dass beide Komponenten, nämlich das Steuerwerk und der Leuchtdioden-Treiber, schützend innerhalb des Gehäuses angeordnet werden. Somit entsteht eine robuste und dennoch kompakte Bauart.

Gemäß einem weiteren Aspekt der vorliegenden Erfindung werden die Leuchtdioden ausschließlich von dem Treiber angesprochen. LED Treiber, Steuerwerk und Kommunikation befinden sich auf einem Chip. Dies hat den Vorteil, dass lediglich eine direkte Verbindung zwischen dem LED Treiber und den Leuchtdioden geschaffen werden muss. Dies impliziert gemäß einem Aspekt der vorliegenden Erfindung, dass innerhalb des Gehäuses keine weiteren Komponenten anzuordnen sind, welche mit den Leuchtdioden kommunizieren. Somit ist es also möglich, in der vorgeschlagenen Anordnung lediglich eine geringe Anzahl von externen Datenleitungen zu implementieren. Dies stellt wiederum sicher, dass die steuernden Komponenten, welche direkt auf die Leuchtdioden einwirken, in einem einzigen Arbeitsschritt in dem gemeinsamen Gehäuse angeordnet werden können. Hierbei wird jedoch nicht ausgeschlossen, dass weitere, übergeordnete Steuereinrichtungen vorzusehen sind, welche jedoch mit dem jeweiligen Steuerwerk kommunizieren. Diese übergeordneten Einheiten können beispielsweise ein Leuchtverhalten der einzelnen Leuchtdioden-Gruppen derart steuern, dass sich ein bestimmter optischer Effekt, beispielsweise eine Welle, einstellt.

Nicht aufgezählt sind vorliegend der LED Treiber und die Kommunikationsschnittstelle. Diese können derart vorgesehen sein, dass die Kommunikationsschnittstelle mit einem dem Gehäuse extern angeordnetem Mikrocontroller kommuniziert. Diese Kommunikationsschnittstelle ist jedoch passiv ausgestaltet und reagiert lediglich auf Anweisungen von dem Mikrocontroller als externer übergeordneter Einheit. Der LED-Treiber nimmt lediglich die Signale des Steuerwerks entgegen. Somit ist das Steuerwerk innerhalb eines Gehäuses die einzige Komponente, die aktiv rechnet und in logischer Weise mit den anderen Komponenten kommuniziert. Beispielsweise erhält das Steuerwerk mittels der Kommunikationseinheit einen Befehl zu Dimmen der LED und berechnet hierzu die Pulsweitenmodulation im dem LED Treiber geeignet anzusteuern. Somit ist also in dem Gehäuse explizit kein Mikrocontroller vorgesehen.

Gemäß einem weiteren Aspekt der vorliegenden Erfindung sind in dem Gehäuse Messeinheiten vorgesehen. Dies hat den Vorteil, dass spezielle Sensoren angeordnet werden können, welche eine Helligkeitsintensität der Leuchtdioden messen. Hierbei ist es möglich absolute Werte der einzelnen Helligkeiten der Leuchtdioden zu erfassen. Entsprechende Verarbeitungsschritte können dann beispielsweise von dem Mikrocontroller durchgeführt werden, der sich in dem gleichen Gehäuse wie die Leuchtdioden befinden. So ist es besonders vorteilhaft, dass die Messeinheiten ebenfalls in technisch einfacher Weise in das Gehäuse integriert werden können und zudem geschützt sind. Somit wird eine effiziente Herstellungsweise verwirklicht.

Gemäß einem weiteren Aspekt der vorliegenden Erfindung sind in dem Gehäuse als aktive funktionale Komponenten ausschließlich die Mehrzahl von Leuchtdioden und das Steuerwerk vorgesehen. Dies hat den Vorteil, dass hierdurch sichergestellt wird, dass das Gehäuse tatsächlich auch derart vorzusehen ist, dass keine weiteren Komponenten eines Bordsystems in dem Gehäuse anzuordnen sind. So erkennt der Fachmann bereits eine Vielzahl von Gehäusen, wobei vorliegend insbesondere ein Gehäuse vorzusehen ist, wie es beispielsweise Leuchtdioden gemäß herkömmlichen Verfahren schützt. Wird nunmehr eine solche Leuchtdiodenbaugruppe in ein Endgerät eingebaut, so könnte fälschlicherweise davon ausgegangen werden, dass eben ein Gehäuse des Endgeräts das erfindungsgemäße Gehäuse ersetzt. Gemäß der vorgeschlagenen technischen Lehre handelt es sich jedoch bei dem Gehäuse um ein Gehäuse, welches typischerweise nur das Steuerwerk und die einzelnen Leuchtdioden umfasst. Hierbei können weitere, passive Komponenten vorgesehen werden. Beispielsweise können Leiterbahnen bzw. Bonddrähte vorgesehen werden. Weitere passive Komponenten können als Kommunikationsschnittstelle oder LED Treiber ausgestaltet sein.

Gemäß einem weiteren Aspekt der vorliegenden Erfindung liegt das Gehäuse als ein Leuchtdioden-Gehäuse vor. Dies hat den Vorteil, dass kein Gehäuse eines externen Endgeräts bzw. ein gesondertes Gehäuse vorgesehen werden muss. Somit wird also ein Gehäuse geschaffen, welches lediglich die Leuchtdioden und das Steuerwerk derart einstückig zusammenfasst, dass eine auswechselbare Komponente entsteht. Somit wird also sichergestellt, dass sich das vorgeschlagene Gehäuse generell auf eine Bauart beschränkt, wie sie typischerweise auch bezüglich Leuchtdioden Verwendung findet. Insbesondere kann es sich hierbei um ein transparentes oder ein semitransparentes Gehäuse handeln. Hierbei sind innerhalb des Gehäuses transparente oder semi-transparente sowie teilweise opake Flächen vorgesehen. Somit ist es also möglich innerhalb dem Gehäuse Fensterbereiche zu schaffen, anhand derer die Leuchtdiode von außerhalb des Gehäuses bezüglich ihrer Helligkeitsintensität wahrnehmbar ist. Hierbei ist es möglich, dass innerhalb des vorgeschlagenen Gehäuses weitere Lichtbarrieren vorzusehen sind. Dies ist deshalb der Fall, da eine UV-Strahlung ein reibungsloses Funktionieren des Steuerwerks verhindern kann. Hierzu wird innerhalb des Gehäuses eine Lackschicht derart vorgesehen, dass das Steuerwerk, innerhalb des Gehäuses vor der Emission der Leuchtdioden geschützt sind. Sind innerhalb des Gehäuses Messeinheiten bzw. Messfühler angeordnet, so ist sicherzustellen, dass diese derart fehlerfrei funktionieren, dass diese Parameter der Leuchtdioden messen bzw. erfassen können. Hierbei kennt der Fachmann Möglichkeiten, wie er innerhalb des Gehäuses transparente Bereiche, beispielsweise unter Verwendung eines transparenten Kunststoffs, schafft.

Gemäß einem weiteren Aspekt der vorliegenden Erfindung liegt die Mehrzahl von Leuchtdioden als eine rote Leuchtdiode, eine grüne Leuchtdiode, eine blaue Leuchtdiode und eine optionale, weiße Leuchtdiode vor. Dies hat den Vorteil, dass bestehende Leuchtdiodenbaugruppen wiederverwendet werden können und insbesondere, dass sich diese Leuchtdioden besonders für die vorgeschlagene Anordnung eignen. Weiterhin ist es besonders vorteilhaft, dass eine weiße Leuchtdiode lediglich optional vorzusehen ist, um auf ein bestimmtes Anwendungsszenario zu reagieren. So wird erfindungsgemäß vorgeschlagen, eine möglichst geringe Anzahl von Leuchtdioden in der vorgeschlagenen Anordnung zu betreiben, da diese eine Wärmeentwicklung erzeugen. Somit hat also eine geringe Anzahl von Leuchtdioden den Vorteil, dass die nachteilige Wärmeentwicklung nach Möglichkeit vermieden wird. Somit wird erfindungsgemäß also gewährleistet, dass trotz der kompakten Bauweise ein Alterungsprozess von Leuchtdioden nicht beschleunigt wird. Da Leuchtdioden generell einem Alterungsprozess unterliegen, der insbesondere auf eine Wärmeentwicklung zurückzuführen ist, ist es also besonders vorteilhaft lediglich drei Leuchtdioden, also eine rote, eine grüne und eine blaue Leuchtdiode, vorzusehen. Generell ist es jedoch möglich eine beliebige Anzahl von Leuchtdioden zu verbauen.

Die Aufgabe wird auch gelöst durch eine Fahrzeugkomponente mit kompakter Leuchtdioden-Anordnung, aufweisend eine Mehrzahl von Leuchtdioden, wobei die Leuchtdioden mitsamt einem Steuerwerk, welches eingerichtet ist, die Helligkeitsintensität der Leuchtdioden jeweils einzustellen, einstückig in einem gemeinsamen Gehäuse angeordnet sind.

Dies ist deshalb vorteilhaft, da insbesondere in einem Fahrzeuginnenraum aber auch generell in einem Fahrzeug spezielle Anforderungen auftreten. Wie bereits eingangs beschrieben, können entsprechende Leuchtdioden einen Warnhinweis bereitstellen, welcher wiederum besonders sicherheitskritisch sein kann. So werden an Leuchtdioden in einem Fahrzeug spezielle Anforderungen gestellt, da diese kompakt, zuverlässig und farbtreu sein müssen. Somit wurde überraschenderweise festgestellt, dass sich die vorgeschlagene Leuchtdioden-Anordnung insbesondere für Fahrzeugkomponenten eignet. So ist die vorliegende Erfindung auch auf Fahrzeugkomponenten an sich gerichtet, die davon profitieren, dass eine kompakte Leuchtdioden-Anordnung vorgesehen wird. So entsteht insbesondere der technische Effekt, dass innerhalb der Fahrzeugkomponente auf einem begrenzten Raum mehr Leuchtdiodeneinheiten angeordnet werden können, als dies gemäß dem Stand der Technik möglich ist.

So schafft die vorliegende Erfindung eine vorteilhafte Leuchtdioden-Anordnung, welche auch in ihrer Geometrie leichter anzupassen ist. Da nunmehr das Steuerwerk nicht mehr extern zu den Leuchtdioden angeordnet ist, können nunmehr nahezu beliebige Geometrie realisiert werden. Insbesondere werden externe Leiterbahnen vermieden, welche gemäß dem Stand der Technik die Leuchtdioden mit dem Steuerwerk verbinden. Da diese Leiterbahnen nicht mehr notwendig sind, bzw. lediglich in sehr geringem Umfang innerhalb des Gehäuses verbaut werden, entsteht ein besonders robuster Aufbau der sich insbesondere in einem Fahrzeug vorteilhaft auswirkt. Überraschenderweise wurde zudem festgestellt, dass sich der vorgeschlagene Aufbau trotz der kompakten Bauweise innerhalb eines Fahrzeugs besonders eignet, da hierbei Leuchtdioden typischerweise nicht in einem Dauerbetrieb eingeschaltet sind.

So können also Fahrzeugkomponenten bereitgestellt werden, welche besonders langlebig sind und dennoch eine Vielzahl von Leuchtdioden aufweisen. Aufgrund kürzerer Einschaltdauern wird also die technische Hürde überwunden, dass die Leuchtdioden in einem Betrieb Wärme abstrahlen und somit das Steuerwerk beeinträchtigen könnten. Während also bekannte Verfahren das Steuerwerk außerhalb des Gehäuses der Leuchtdioden anordnen, ist es erfindungsgemäß besonders vorteilhaft trotz der technischen Hürde der Wärmeentwicklung das Steuerwerk innerhalb des Gehäuses anzuordnen. Somit kann auch ein längerer Betrieb der Leuchtdioden von mehreren Stunden in Kauf genommen werden, da hier noch keine Beeinträchtigung durch die Wärmeentwicklung zu erwarten ist.

Insbesondere ist die vorgeschlagene Anordnung auch deshalb vorteilhaft, da in effizienter Art und Weise ein Gehäuse auch für das Steuerwerk geschaffen werden kann, welches es vor Feuchtigkeit schützt. Gleiches gilt für Leiterbahnen, welche nunmehr nicht mehr extern angeordnet werden, sondern vielmehr ebenfalls in dem Gehäuse angeordnet werden können, da sowohl Steuerwerk und auch Leuchtdioden in dem gleichen Gehäuse verbaut sind. Somit werden also Fahrzeugkomponenten bereitgestellt, die zudem besonders geschützt sind, ohne dass hierbei ein großer technischer Aufwand entsteht. Hierbei kommt der besondere Schutz durch das gemeinsame Gehäuse nicht lediglich bei verbauten Fahrzeugkomponenten zum Einsatz, sondern vielmehr wird durch das gemeinsame Gehäuse bereits sichergestellt, dass die gelagerten Komponenten geschützt sind und über einen längeren Zeitraum vorgehalten werden können.

Gemäß einem weiteren Aspekt der vorliegenden Erfindung liegt die Fahrzeugkomponente als eine Zierleiste, ein Innenspiegel, ein Außenspiegel, eine Warnleuchte, eine Innenleuchte und/ oder eine Fahrzeugleuchte vor. Dies hat den Vorteil, dass beispielsweise bei einer Zierleiste der technische Effekt auftritt, dass eine Vielzahl von Leuchtdioden aufgrund der kompakten Bauweise in einem vorgegebenen Raum verbaut werden kann. Dies kommt insbesondere im Fahrzeug Innenraum zum Tragen, der stets begrenzt ist. Insbesondere lassen sich durch die erfindungsgemäße Anordnung besonders ästhetische Effekte durch die Vielzahl der zu verbauenden Leuchtdioden einstellen. Bezüglich einem Innenspiegel oder einer Warnleuchte stellt sich der Vorteil ein, dass wiederum eine Vielzahl von Leuchtdioden verbaut werden kann ohne dass hierbei die Farbtreue oder Zuverlässigkeit beeinträchtigt wird. So sind bei solchen Komponenten die Betriebsdauern der Leuchtdioden relativ kurz, weshalb eine geringe Wärmeentwicklung und ein geringerer Alterungsprozess zu erwarten ist. Somit behalten also beispielsweise Warnleuchten über einen langen Zeitraum die gewünschte Farbe und büßen nicht an Unzuverlässigkeit ein. Da der Alterungsprozess gering ist, wird auch die Helligkeitsintensität nur geringfügig beeinflusst, weshalb die vorgeschlagene Fahrzeugkomponente eben auch als Innenleuchte einsetzbar ist.

Gemäß einem weiteren Aspekt der vorliegenden Erfindung sind mehrere Leuchtdioden-Anordnungen in Serie geschaltet. Dies hat den Vorteil, dass eine beliebige Geometrie geschaffen werden kann, derart, dass eine Vielzahl von Leuchtdiodenbaugruppen gemeinsam angesprochen werden kann und sich somit ein gewünschtes Bild darstellt. So wird der technische Vorteil der kompakten Bauweise deshalb besonders betont, da sich die Platzeinsparungen der vorgeschlagenen Leuchtdioden-Anordnungen addieren und somit besonders zum Tragen kommen.

Die Aufgabe wird auch gelöst durch ein Verfahren zur Herstellung einer kompakten Leuchtdioden-Anordnung zur Verwendung in einem Fahrzeug, aufweisend ein Bereitstellen einer Mehrzahl von Leuchtdioden, wobei ein Bereitstellen eines Steuerwerks erfolgt, welches eingerichtet ist, die Helligkeitsintensität der Leuchtdioden jeweils einzustellen und ein Anordnen der bereitgestellten Mehrzahl von Leuchtdioden und des bereitgestellten Steuerwerks einstückig in einem gemeinsamen Gehäuse erfolgt.

Das vorgeschlagene Verfahren eignet sich somit zur Herstellung einer Baugruppe, wie sie bereits beschrieben wurde. Insbesondere eignet sich das Verfahren zur Herstellung einer Fahrzeugkomponente.

Gemäß einem weiteren Aspekt der vorliegenden Erfindung wird die Leuchtdioden-Anordnung in eine Fahrzeugkomponente eingebracht. Dies hat den Vorteil, dass eine bestehende Fahrzeugkomponente derart erfinderisch aufgerüstet werden kann, dass die kompakte Leuchtdioden-Anordnung dort verwendet wird. Somit lassen sich also auch bereits produzierte Fahrzeugkomponenten besonders vorteilhaft aufrüsten. Dies ermöglicht es auch das vorgeschlagene Verfahren in einen bestehenden Produktionsablauf einzugliedern.

Gemäß am weiteren Aspekt der vorliegenden Erfindung wird die Fahrzeugkomponente als eine Zierleiste, ein Innenspiegel, ein Außenspiegel, eine Warnleuchte, eine Innenleuchte und/ oder eine Fahrzeugleuchte ausgestaltet. Dies hat den Vorteil, dass eine Vielzahl von bestehenden Fahrzeugkomponenten Wiederverwendung finden kann und erfinderisch aufgerüstet werden kann.

Gemäß einem weiteren Aspekt der vorliegenden Erfindung wird das Anordnen der bereitgestellten Mehrzahl von Leuchtdioden und des bereitgestellten Steuerwerks in dem Gehäuse in einem Arbeitsschritt ausgeführt. Dies hat den Vorteil, dass beispielsweise gleichzeitig die Leuchtdioden und das Steuerwerk in das Gehäuse integriert werden können, weshalb wenig technischer Aufwand zur Realisierung der vorgeschlagenen Erfindung notwendig ist. So werden also gegenüber dem Stand der Technik die Herstellungsprozesse wesentlich vereinfacht und es sind insgesamt weniger Arbeitsschritte vorzusehen.

Die Aufgabe wird auch gelöst durch ein Computerprogrammprodukt mit Steuerbefehlen, welche das vorgeschlagene Verfahren implementieren. Somit kann das Verfahren als Software oder hardwaretechnisch bereitgestellt werden.

Erfindungsgemäß ist es besonders vorteilhaft, dass sich das Verfahren zur Herstellung der vorgeschlagenen Anordnung eignet und somit strukturelle Merkmale der Anordnung auch entsprechend als Verfahrensschritte nachgebildet werden können. So werden aufgezeigte strukturelle Merkmale durch mindestens einen Verfahrensschritt in der Herstellung realisiert. Ferner schaffen die einzelnen Verfahrensschritte strukturelle Merkmale, welche sich in der vorgeschlagenen Anordnung niederschlagen. Hierbei ist das Computerprogrammprodukt geeignet Steuerbefehle bereitzustellen, welche die entsprechenden Verfahrensschritte implementieren.

Weitere vorteilhafte Ausgestaltungen werden anhand der beigefügten Figuren näher erläutert. Es zeigen:
- Figur 1:: ein Blockschaltbild, welches eine Leuchtdioden-Anordnung zeigt, wie es erfindungsgemäß anzupassen ist;
- Figur 2:: ein Blockschaltbild, welches eine Leuchtdioden-Anordnung zeigt, wie es erfindungsgemäß anzupassen ist;
- Figur 3:: ein Blockschaltbild einer kompakten Leuchtdioden-Anordnung gemäß einem Aspekt der vorliegenden Erfindung;
- Figur 4:: ein Blockschaltbild einer kompakten Leuchtdioden-Anordnung mit in Serie geschalteter Leuchtdiodenvorrichtungen gemäß einem Aspekt der vorliegenden Erfindung; und
- Figur 5:: ein schematisches Ablaufdiagramm eines Verfahrens zur Herstellung einer kompakten Leuchtdioden-Anordnung gemäß einem weiteren Aspekt der vorliegenden Erfindung.

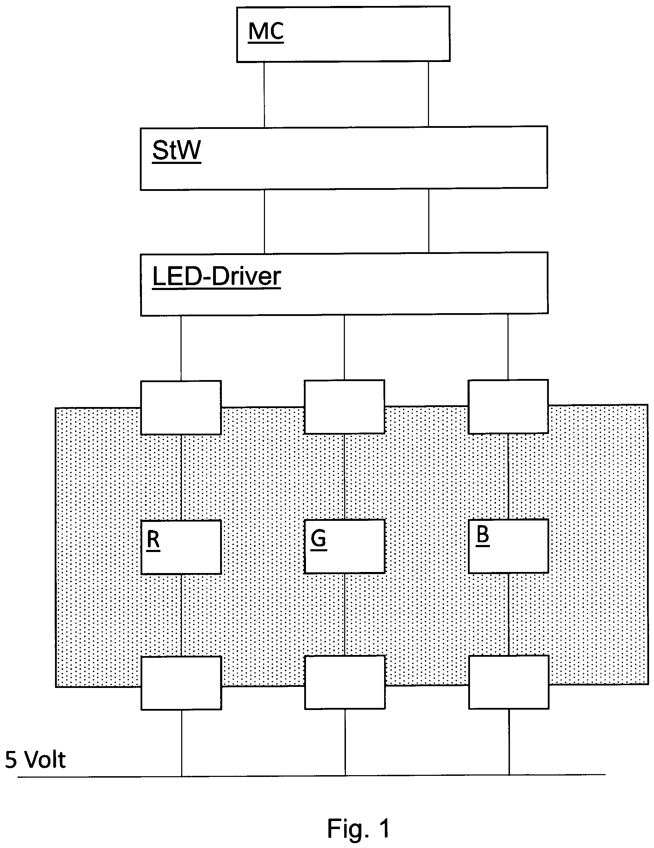

Figur 1 zeigt oben einen Mikrocontroller MC, der mit einem LED-Treiber kommuniziert. Über entsprechende Pins bzw. Bonds treten ist der LED-Treiber mit den Leuchtdioden verbunden. Hierbei wird ersichtlich, dass außerhalb des Gehäuses, welches vorliegend unten dargestellt es, mehrere Leiterbahnen notwendig sind, die den LED-Treiber und das Gehäuse sowie den Mikrocontroller MC und das Steuerwerk StW mit dem LED-Treiber verbinden. Dies ist besonders fehleranfällig und aufwendig in der Herstellung. Hierbei besteht zudem die technische Hürde entsprechende externe Baugruppen in das gemeinsame Gehäuse zu integrieren, da hierbei eine Wärmeentwicklung der Leuchtdioden nachteilig ist. Erfindungsgemäß wurde jedoch erkannt, dass bei einer Verwendung der entsprechenden Leuchtdioden-Anordnung in einem Fahrzeug keine Wärmeentwicklung zu erwarten ist, die einer solchen Bauart schadet. Insbesondere ist es technisch schwierig entsprechende Baugruppen innerhalb des Gehäuses anzuordnen, da es sich hierbei um sehr feine Strukturen handelt, weshalb der Fachmann stets entsprechende Komponenten extern zu dem Gehäuse anordnet.

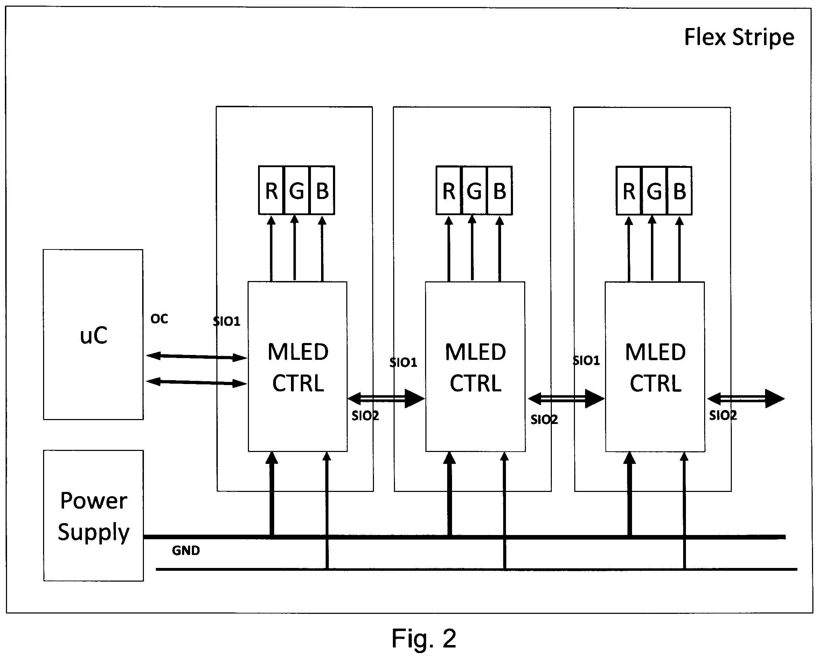

Figur 2 zeigt Steuereinheiten in Form von Controllern. Bei den Steuereinheiten kann es sich um sogenannte Multi-LED-Controller handeln. Dies ist in der vorliegenden Figur 2 als MLED CTRL eingezeichnet. Als ein Mikrocontroller MC oder Controller werden allgemein Halbleiterchips bezeichnet, die einen Prozessor und zugleich auch Peripheriefunktionen enthalten. Das Steuerwerk StW, auch Programmsteuerwerk oder Leitwerk, ist eine Funktionseinheit eines Prozessors, die den Ablauf der Befehlsverarbeitung steuert, somit Befehle lädt, gegebenenfalls decodiert und interpretiert. Somit sind Controller und Steuerwerke in ihrem Funktionsumfang verschieden. Hier übernimmt der MLED Controller die Aufgabe der Ansteuerung der LEDs. Da die einzelnen MLED Controller über kein Steuerwerk verfügen können diese stets nur über den Mikrocontroller angesprochen werden. Auch ist es beispielsweise bekannt einen Hauptcontroller, also einen sogenannten Main Controller, vorzusehen. Diese Komponenten sind jedoch oftmals nicht einstückig ausgeformt. Zudem können bekannte Controller oftmals nicht die Helligkeitsintensität einstellen, sondern lediglich das Mischverhältnis der LEDs um einen Farbwert bereitzustellen. Zudem sind Gehäuse bekannt bei denen die LEDs nicht in dem Gehäuse angeordnet sind, sondern daraus herausragen. Dies widerspricht jedoch der vorliegenden Erfindung, die eine kompakte Bauart vorsieht. Da es sich bei Figur 2 um eine Aufsicht handelt, ist hier eine Bauart beschrieben, die vorsieht, dass die Leuchtdioden aus dem Gehäuse herausragen.

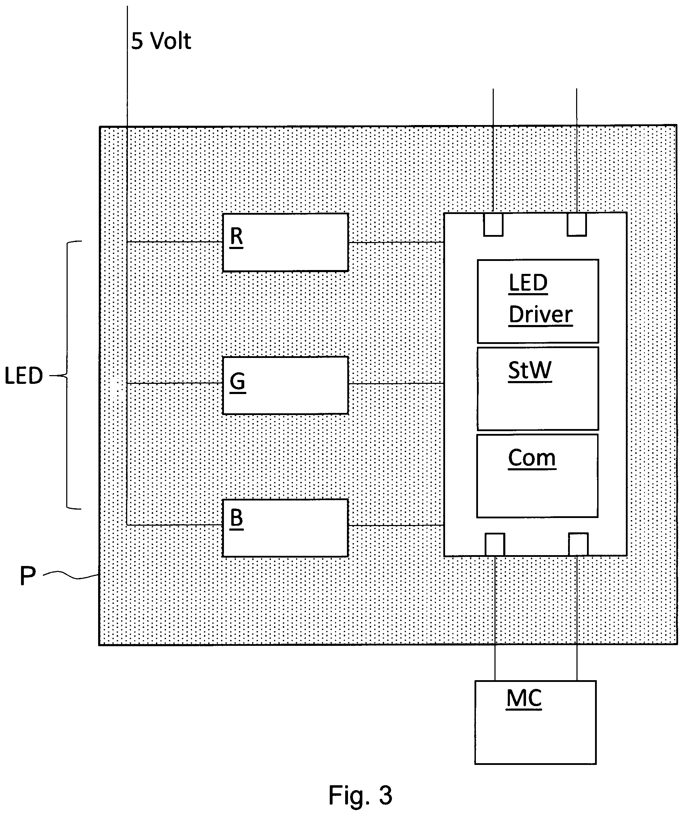

Figur 3 zeigt die nunmehr das erfindungsgemäße LED-Gehäuse P, welches sowohl das Steuerwerk auf der rechten Seite als auch die einzelnen Leuchtdioden R, G und B auf der linken Seite vorsieht. Somit wird also bewerkstelligt, dass ein einziges gemeinsames Gehäuse P vorzusehen ist, welches sowohl die Leuchtdioden als auch das Steuerwerk schützt. Bei dem Gehäuse handelt es sich um ein Gehäuse P, welches Sichtfenster aufweist, derart dass die Leuchtintensität der Leuchtdioden von außerhalb des Gehäuses P wahrnehmbar ist. Als Gehäuse eignet sich insbesondere ein Chipgehäuse, auch als Package P bezeichnet.

Hierbei ist es möglich, das Steuerwerk StW und den LED-Treiber einstückig auszugestalten oder aber auch in der vorliegenden Ansicht das Steuerwerk StW oben und den LED-Treiber unten anzuordnen. Ferner ist es auch möglich den Treiber zwischen den Leuchtdioden und dem Steuerwerk StW anzuordnen. Hierbei tritt wiederum der Vorteil auf, dass sich beliebige Geometrien realisieren lassen und somit eine Vielzahl von Anwendungsszenarien möglich ist. Somit wird also eine besonders kompakte Bauweise geschaffen, ohne dass hierbei Alterungsprozesse signifikant in Erscheinung treten.

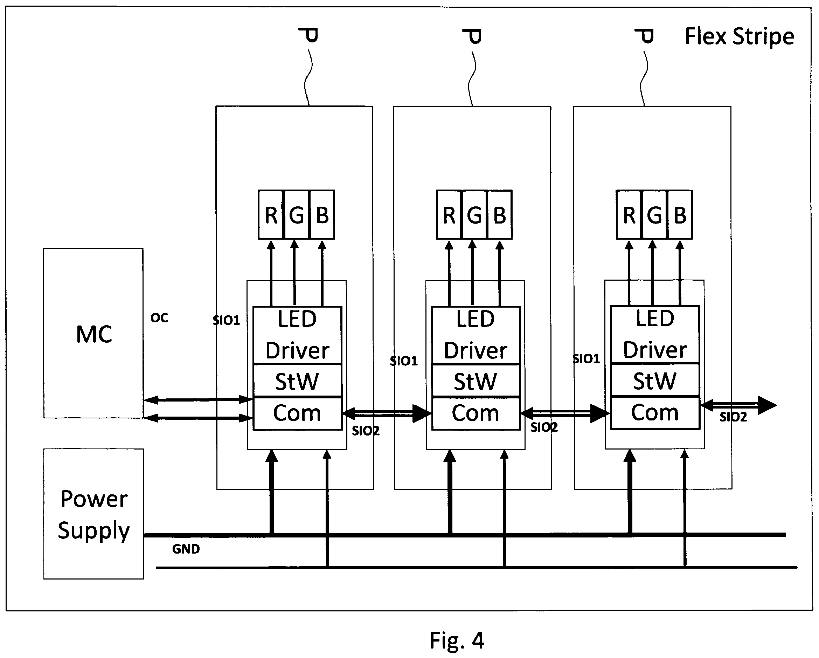

Figur 4 zeigt in Serie geschaltete Leuchtdioden mit einem gesondertem LED Treiber, einem gesondertem Steuerwerk und einer gesonderten Kommunikationsschnittstelle Com. Hierbei wurde also das Steuerwerk in das Gehäuse P verlagert und gegenüber bekannten Anordnungen ist das Steuerwerk StW, welches eingerichtet ist, die Helligkeitsintensität der Leuchtdioden LED jeweils einzustellen, einstückig in dem gemeinsamen Gehäuse P angeordnet. So ist es erfindungsgemäß möglich, dass ein Mikrocontroller MC einen Befehl ausgibt und hierbei lediglich eine Auswahl an Leuchtdioden anspricht. Somit kann gleichzeitig eine Mehrzahl von Leuchtdioden angesprochen werden. Beispielsweise werden die erste und die dritte Leuchtdiode angesprochen. Die Kommunikationsschnittstelle Com nimmt jeweils den Befehl entgegen. Das jeweilige Steuerwerk erkennt, ob dessen Kennung angesprochen wurde und leitet das Signal an den LED Driver weiter. So erkennt beispielsweise das erste Steuerwerk, dass es angesprochen wurde, decodiert einen Helligkeitswert und steuert den LED Treiber derart an, dass dieser die Intensität einstellt. Dies stellt ebenfalls lediglich einen Aspekt der Erfindung dar.

Hierbei ist es im Gegensatz zu bekannten Verfahren möglich, dass das Steuerwerk ausschließlich ein Ansteuersignal für den LED Treiber errechnen kann. Somit kann das Steuerwerk eine Pulsweitenmodulation durchführen und die Amplitude variieren. Somit kann also das Farbschema der Leuchtdiode LED mittels des Mischverhältnisses eingestellt werden, die Helligkeitsintensität mittels einer Pulsweitenmodulation eingestellt werden und die Helligkeitsintensität mittels einer Amplitude des Signals der Pulsweitenmodulation eingestellt werden. Somit können keine Peripheriefunktionen bereitgestellt werden, wie dies ein Controller oder ein Mikrocontroller tut. Somit wird eine besonders effiziente Bauart geschaffen, die effizient bereitgestellt werden kann.

Die LED Treiber kommunizieren also allein und direkt mit den Leuchtdiodeneinheiten RGB ohne, dass hierzu ein Controller notwendig ist. Somit stellt sich der Vorteil ein, dass die Komponenten gesondert und spezialisiert hergestellt werden können. Beispielsweise können genormte LED Treiber wiederverwendet werden, während spezialisierte Steuerwerke StW verbaut werden können. Bei Leuchtdioden mit einem gesondertem LED Treiber, einem gesondertem Steuerwerk und einer gesonderten Kommunikationsschnittstelle können diese also als eigene, separate Komponenten bereitgestellt werden und der jeweilige Funktionsumfang kann individualisiert eingestellt werden. Erst bei einem Zusammenbau können diese einstückig und somit kompakt angeordnet werden.

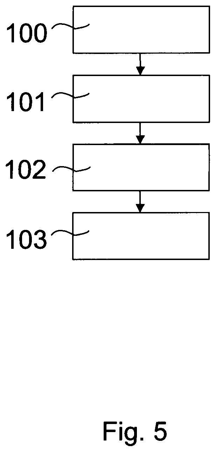

Figur 5 zeigt ein schematisches Ablaufdiagramm eines Verfahrens zur Herstellung einer kompakten Leuchtdioden-Anordnung zur Verwendung in einem Fahrzeug, aufweisend ein Bereitstellen 100 einer Mehrzahl von Leuchtdioden, wobei ein Bereitstellen eines Steuerwerks 101 erfolgt, welches eingerichtet ist, die Helligkeitsintensität der Leuchtdioden jeweils einzustellen, und ein Anordnen 102 der bereitgestellten Mehrzahl von Leuchtdioden und des bereitgestellten Steuerwerks einstückig in einem gemeinsamen Gehäuse erfolgt. Hierbei erkennt der Fachmann, dass die vorgeschlagenen Verfahrensschritte iterativ und/ oder in anderer Reihenfolge ausgeführt werden können. Beispielsweise kann das Bereitstellen des Steuerwerks schon vor dem Bereitstellen der Leuchtdioden erfolgen. Ferner können auch mehrere Leuchtdioden bereitgestellt werden, welche mitsamt dem Steuerwerk in einem gemeinsamen Gehäuse angeordnet werden.

Vorliegend nicht gezeigt ist ein Computerprogrammprodukt mit Steuerbefehlen, welche das vorgeschlagene Verfahren implementieren. Generell kann das Verfahren als Software oder hardwaretechnisch bereitgestellt werden.

## Patentansprüche

1. Kompakte Leuchtdioden-Anordnung zur Verwendung in einem Fahrzeug, aufweisend eine Mehrzahl von Leuchtdioden (LED), wobei die Leuchtdioden (LED) mitsamt einem Steuerwerk (StW), welches eingerichtet ist, die Helligkeitsintensität der Leuchtdioden (LED) jeweils einzustellen, einstückig in einem gemeinsamen Chipgehäuse (P) angeordnet sind und innerhalb des Gehäuses (P) transparente oder semi-transparente sowie teilweise opake Flächen vorgesehen sind um Fensterbereiche zu schaffen, anhand derer die Leuchtdiode (LED) von außerhalb des Gehäuses bezüglich ihrer Helligkeitsintensität wahrnehmbar ist, dadurch gekennzeichntet, dass eine Lackschicht derart vorgesehen ist, dass das Steuerwerk (StW) nnerhalb des Gehäuses (P) vor der Emission der Leuchtdioden (LED) geschützt ist.

2. Leuchtdioden-Anordnung nach Anspruch 1, **dadurch gekennzeichnet, dass** das Steuerwerk (StW) mitsamt einer Kommunikationseinheit (Com) und einem Leuchtdioden-Treiber in dem Chipgehäuse (P) verbaut ist.

3. Leuchtdioden-Anordnung nach Anspruch 1 oder 2, **dadurch gekennzeichnet, dass** die Leuchtdioden (LED) ausschließlich von dem Steuerwerk (StW) angesprochen werden.

4. Leuchtdioden-Anordnung nach einem der vorhergehenden Ansprüche, **dadurch gekennzeichnet, dass** in dem Chipgehäuse (P) Messeinheiten vorgesehen sind.

5. Leuchtdioden-Anordnung nach einem der Ansprüche 1 oder 3, **dadurch gekennzeichnet, dass** in dem Chipgehäuse (P) als aktive funktionale Komponenten ausschließlich die Mehrzahl von Leuchtdioden (LED) und das Steuerwerk (StW) vorgesehen sind.

6. Leuchtdioden-Anordnung nach einem der vorhergehenden Ansprüche, **dadurch gekennzeichnet, dass** die Mehrzahl von Leuchtdioden (LED) als eine Rot-Leuchtdiode (R), eine Grün-Leuchtdiode (G), eine Blau-Leuchtdiode (B) und eine optionale Weiß-Leuchtdiode vorliegt.

7. Fahrzeugkomponente mit kompakter Leuchtdioden-Anordnung gemäß Anspruch 1.

8. Fahrzeugkomponente nach Anspruch 7, **dadurch gekennzeichnet, dass** die Fahrzeugkomponente als eine Zierleiste, ein Innenspiegel, ein Außenspiegel, eine Warnleuchte, eine Innenleuchte und/ oder eine Fahrzeugleuchte vorliegt.

9. Fahrzeugkomponente nach Anspruch 7 oder 8, **dadurch gekennzeichnet, dass** mehrere Leuchtdioden-Anordnungen in Serie geschaltet sind.

10. Verfahren zur Herstellung einer kompakten Leuchtdioden-Anordnung zur Verwendung in einem Fahrzeug, aufweisend ein Bereitstellen (100) einer Mehrzahl von Leuchtdioden (LED), wobei ein Bereitstellen (101) eines Steuerwerks (StW) erfolgt, welches eingerichtet ist, die Helligkeitsintensität der Leuchtdioden (LED) jeweils einzustellen, und ein Anordnen (102) der bereitgestellten Mehrzahl von Leuchtdioden (LED) und des bereitgestellten Steuerwerks (StW) einstückig in einem gemeinsamen Chipgehäuse (P) erfolgt und innerhalb des Gehäuses (P) transparente oder semi-transparente sowie teilweise opake Flächen vorgesehen werden um Fensterbereiche zu schaffen, anhand derer die Leuchtdiode (LED) von außerhalb des Gehäuses bezüglich ihrer Helligkeitsintensität wahrnehmbar ist, **dadurch gekennzeichnet, dass** eine Lackschicht derart vorgesehen wird, dass das Steuerwerk (StW), innerhalb des Gehäuses (P) vor der Emission der Leuchtdioden (LED) geschützt ist.

11. Verfahren nach Anspruch 10, **dadurch gekennzeichnet, dass** die Leuchtdioden-Anordnung in eine Fahrzeugkomponente eingebracht (103) wird.

12. Verfahren nach Anspruch 11, **dadurch gekennzeichnet, dass** die Fahrzeugkomponente als eine Zierleiste, ein Innenspiegel, ein Außenspiegel, eine Warnleuchte, eine Innenleuchte und/ oder eine Fahrzeugleuchte ausgestaltet wird.

13. Verfahren nach einem der Ansprüche 10 bis 12, **dadurch gekennzeichnet, dass** das Anordnen (102) der bereitgestellten Mehrzahl von Leuchtdioden und des bereitgestellten Steuerwerks (StW) in dem Chipgehäuse (P) in einem Arbeitsschritt ausgeführt wird.

## Claims

1. A compact light-emitting diode arrangement for use in a vehicle, comprising a plurality of light-emitting diodes, wherein the light-emitting diodes along with a control mechanism, which is arranged to set the brightness intensity of the light-emitting diodes individually, are arranged in one piece in a common chip housing and transparent or semi-transparent as well as partially opaque surfaces are provided within the chip housing to provide window regions, through which the brightness intensity of the light-emitting diode is observable from outside the chip housing, **characterized in that** a lacquer layer is arranged such that the control mechanism is protected within the housing against the emission of the light-emitting diodes.

2. The light-emitting diode arrangement as claimed in claim 1, **characterized in that** the control mechanism along with a communications unit and a light-emitting diode driver are installed in the chip housing.

3. The light-emitting diode arrangement as claimed in claim 1 or 2, **characterized in that** the light-emitting diodes are activated exclusively by the control mechanism.

4. The light-emitting diode arrangement as claimed in one of the previous claims, **characterized in that** measuring units are provided in the chip housing.

5. The light-emitting diode arrangement as claimed in claim 1 or 3, **characterized in that** the plurality of light-emitting diodes and the control mechanism are provided exclusively as active functional components in the chip housing.

6. The light-emitting diode arrangement as claimed in one of the previous claims, **characterized in that** the plurality of light-emitting diodes are provided as a red light-emitting diode, a green light-emitting diode, a blue light-emitting diode and an optional white light-emitting diode.

7. A vehicle component comprising a compact light-emitting diode arrangement as claimed in claim 1.

8. The vehicle component as claimed in claim 7, **characterized in that** the vehicle component is provided as a trim strip, an interior rear-view mirror, an exterior rear-view mirror, a warning light, an interior light and/or a vehicle light.

9. The vehicle component as claimed in claim 7 or 8, **characterized in that** a plurality of light-emitting diode arrangements are connected in series.

10. A method for producing a compact light-emitting diode arrangement for use in a vehicle, comprising providing a plurality of light-emitting diodes, wherein a control mechanism is provided which is arranged to set the brightness intensity of the light-emitting diodes individually, and the provided plurality of light-emitting diodes and the provided control mechanism are arranged in one piece in a common chip housing and transparent or semi-transparent as well as partially opaque surfaces are provided within the chip housing to provide window regions, through which the brightness intensity of the light-emitting diode is observable from outside the chip housing **characterized in that** a lacquer layer is arranged such that the control mechanism is protected within the housing against the emission of the light-emitting diodes.

11. The method as claimed in claim 10, wherein the light-emitting diode arrangement is introduced into a vehicle component.

12. The method as claimed in claim 11, wherein the vehicle component is designed as a trim strip, an interior rear-view mirror, an exterior rear-view mirror, a warning light, an interior light and/or a vehicle light.

13. The method as claimed in claims 10 to 12, wherein the step of arranging the provided plurality of light-emitting diodes and the provided control mechanism in the chip housing is performed in one working step.

## Revendications

1. Ensemble compact de diodes électroluminescentes destiné à être utilisé dans un véhicule, présentant une pluralité de diodes électroluminescentes, dans lequel les diodes électroluminescentes sont disposées en un seule pièce dans un boîtier de puce conjointement avec une unité de commande qui est conçue pour régler l'intensité lumineuse de chacune des diodes électroluminescentes, et des surfaces transparentes ou semi-transparentes ainsi que partiellement opaques sont prévues à l'intérieur du boîtier pour créer des zones de fenêtre au moyen desquelles l'intensité lumineuse de la diode électroluminescente peut être perçue de l'extérieur du boîtier, **caractérisé en ce qu'**une couche de vernis est prévue de telle sorte que l'unité de commande à l'intérieur du boîtier soit protégée contre l'émission des diodes électroluminescentes.

2. Ensemble de diodes électroluminescentes selon la revendication 1, **caractérisé en ce que** l'unité de commande est installée dans le boîtier de puce conjointement avec une unité de communication et un circuit d'attaque de diodes électroluminescentes.

3. Ensemble de diodes électroluminescentes selon la revendication 1 ou 2, **caractérisé en ce que** les diodes électroluminescentes sont activées uniquement par l'unité de commande.

4. Ensemble de diodes électroluminescentes selon l'une des revendications précédentes, **caractérisé en ce que** des unités de mesure sont prévues dans le boîtier de puce.

5. Ensemble de diodes électroluminescentes selon l'une des revendications 1 ou 3, **caractérisé en ce que** seules la pluralité de diodes électroluminescentes et l'unité de commande sont prévues dans le boîtier de puce en tant que composants fonctionnels actifs.

6. Ensemble de diodes électroluminescentes selon l'une des revendications précédentes, **caractérisé en ce que** la pluralité de diodes électroluminescentes est présente sous la forme d'une diode électroluminescente rouge, d'une diode électroluminescente verte, d'une diode électroluminescente bleue et d'une diode électroluminescente blanche optionnelle.

7. Composant de véhicule avec un ensemble compact de diodes électroluminescentes selon la revendication 1.

8. Composant de véhicule selon la revendication 7, **caractérisé en ce que** le composant de véhicule est présent sous la forme d'une baguette enjoliveuse, d'un rétroviseur intérieur, d'un rétroviseur extérieur, d'un voyant d'avertissement, d'un luminaire intérieur et/ou d'un feu de véhicule.

9. Composant de véhicule selon la revendication 7 ou 8, **caractérisé en ce que** plusieurs ensembles de diodes électroluminescentes sont connectés en série.

10. Procédé de fabrication d'un ensemble compact de diodes électroluminescentes destiné à être utilisé dans un véhicule, présentant les étapes consistant à mettre à disposition une pluralité de diodes électroluminescentes, à mettre à disposition une unité de commande, qui est conçue pour régler l'intensité lumineuse de chacune des diodes électroluminescentes, et à disposer la pluralité de diodes électroluminescentes mise à disposition et l'unité de commande mise à disposition en une seule pièce dans un boîtier de puce commun, et dans lequel des surfaces transparentes ou semi-transparentes ainsi que partiellement opaques sont prévues à l'intérieur du boîtier pour créer des zones de fenêtre au moyen desquelles l'intensité lumineuse de la diode électroluminescente peut être perçue de l'extérieur du boîtier, **caractérisé en ce qu'**une couche de vernis est prévue de telle sorte que l'unité de commande à l'intérieur du boîtier soit protégée contre l'émission des diodes électroluminescentes.

11. Procédé selon la revendication 10, **caractérisé en ce que** l'ensemble de diodes électroluminescentes est placé dans un composant de véhicule.

12. Procédé selon la revendication 11, **caractérisé en ce que** le composant de véhicule est réalisé sous la forme d'une baguette enjoliveuse, d'un rétroviseur intérieur, d'un rétroviseur extérieur, d'un voyant d'avertissement, d'un luminaire intérieur et/ou d'un feu de véhicule.

13. Procédé selon l'une des revendications 10 à 12, **caractérisé en ce que** l'étape consistant à disposer la pluralité de diodes électroluminescentes mise à disposition et de l'unité de commande mise à disposition dans le boîtier de puce est réalisée en une seule opération.
